## Europäisches Patentamt

## European Patent Office

## Office européen des brevets

(19)

(11) Publication number: **0 114 256**
**B1**

(12) **EUROPEAN PATENT SPECIFICATION**

(45) Date of publication of patent specification: **20.04.88**

(51) Int. Cl.⁴: **H 03 K 19/088**

(21) Application number: **83111938.3**

(22) Date of filing: **29.11.83**

(54) Improved TTL circuit.

(30) Priority: **23.12.82 US 452541**

(43) Date of publication of application:
**01.08.84 Bulletin 84/31**

(45) Publication of the grant of the patent:
**20.04.88 Bulletin 88/16**

(84) Designated Contracting States:
**DE FR GB IT**

(56) References cited:
**IBM TECHNICAL DISCLOSURE BULLETIN, Vol. 13, No. 2, July 1970, page 435, New York (US), L.C.WU: "Circuit with negative feedback" INTERNATIONAL CONFERENCE ON COMMUNICATRIONS, June 14-16, 1971, pages 16-23 - 16-28. MONTREAL (CA), IEEE, NEW YORK (US). R:D. BURTNESS: 810A PBX Semiconductor integrated circuits and hybrid technology"**
**I.E.E.E. TRANSACTIONS ON NUCLEAR; Vol NS-18, No. 1, February 18, 1971, pages 249-257, NEW YORK (US). B.D. MARTIN et al:"Advanced data systems for the grand tour".**

(73) Proprietor: **International Business Machines Corporation**
**Old Orchard Road**
**Armonk, N.Y. 10504 (US)**

(72) Inventor: **Blumberg, Richard Jay**
**197 Cedar Ave.**
**Poughkeepsie, N.Y. 12603 (US)**
Inventor: **Brenner, Stewart**
**20 Doyle Drive**
**Wappingers Falls, N.Y. 12590 (US)**
Inventor: **Robortaccio, Rocco Joseph**
**Ridgeview Road**
**Hopewell Junction, N.Y. 22533 (US)**

(74) Representative: **Möhlen, Wolfgang C., Dipl.-Ing.**
**IBM Corporation Säumerstrasse 4**
**CH-8803 Rüschlikon (CH)**

(56) References cited:
**IBM Technical Disclosure Bulletin, Vol. 25, No. 3A, Auguat 1982, pages 978-979, NEW YORK (US). F.J. CRISPI et al: "TTL cell with maximum wirability".**

Courier Press, Leamington Spa, England.

## Description

The invention relates to an improved high speed digital logic circuit and more particularly to an improved high speed digital TTL logic circuit. The logic circuit of the invention lends itself to ready fabrication in integrated circuit form.

The operating requirements for integrated circuits employed in performing logic functions are becoming more stringent as the art of digital computers and data processing equipment advances. In particular, the time required for a circuit to perform a logic operation is a limiting factor in the data handling capability of computering apparatus. Problems are also encountered in providing integrated circuits which are sufficiently immune to noise, whether generated within or externally of the circuit. Logic circuits may also be restricted in their usefulness because of limited "fan-out". "Fan-out" is a measure of the number of succeeding logic circuits which can be operated from the output connection of the circuit.

Size is also a significant consideration in the high speed data processing art. A plurality of interconnected logic circuits has been designed for fabrication within a single chip or die of semiconductor material. However, integrated logic circuits have certain problems in addition to those common to logic circuits in general. The ability to dissipate power is limited, and this situation may result in restricting the circuit to low fan-out and/or large gate delays. Since all of the individual circuit elements (e.g. transistors, diodes, resistors etc.) are located on a single small piece of semiconductor materials (i.e. a chip), there are wireability considerations which must be taken into account.

Various types of digital logic circuits have been developed for fabrication as integrated circuits. Of these, the so-called transistor-transistor type logic (TTL) has become widely accepted because of the availability of certain circuits having favorable switching speeds, power dissipation, immunity to noise, fan-out, and capacitive load driving capability. The TTL logic technology is well known in the art. A sizeable number of patents, publications and texts disclose and discuss the design of TTL logic circuits. Reference is made, for example, to the texts:

(1) "Designing with TTL Integrated Circuits" by R. L. Morris and J. R. Miller, McGraw Hill, New York, New York, Copyright 1971; and

(2) "Digital Integrated Electronics" by Herbert Taub and Donald Schilling, McGraw Hill, New York, New York, Copyright 1977.

The patent and publications fully identified hereinafter are a small selection to generally represent the state of the art of TTL type circuitry.

U.S. Patent 4,069,428 entitled "Transistor-Transistor-Logic Circuit".

IBM Technical Disclosure Bulletin Publications:

—"Unsaturated Transistor Logic Gate" by S. Wiedmann, Vol. 12, No. 11, April 1970, pages 2010—2011.

—"Antisaturation Circuit" by J. A. Palmieri, Vol. 13, No. 2, July 1970, page 428.

—"Low Voltage TTL Circuit" by K. P. Johnson et al, Vol. 14, No. 10, March 1972, pages 2859—2860.

—"Transistor-Transistor Logic Circuit" by H. H. Berger et al, Vol. 16, No. 8, January 1974, page 2643.

—"Push-Pull TTL Internal Circuit" by A. H. Dansky, Vol 23, No. 4, September 1980, pages 1431—1432.

Improved TTL circuitry was disclosed in the following publications:

(a) F. J. Crispi et al. "TTL Cell with Maximum Wirability"; IBM Technical Disclosure Bulletin, Vol. 25, No. 3A, pp. 978—979: Describes a TTL cell comprising a multiple-emitter input transistor whose base is connected through a resistor to a potential source, and whose collector is connected to the base of an output transistor and also through a resistor to the potential source. The emitter of the output transistor is connected to ground, and its collector which is the cell output terminal is also connected through a resistor to the potential source. Diodes are provided between the base and the collector of both, the input transistor and the output transistor.

(b) L. C. Wu "Circuit with Negative Feedback"; IBM Technical Disclosure Bulletin, Vol. 13, No. 2, July 1970, p. 435: Describes a NAND gate circuit comprising a multiple-emitter input transistor whose base is connected through a series-connexion of two resistors to a potential source, and an output transistor whose emitter is connected to ground and whose collector which is the cell output terminal is also connected through a resistor to the potential source. A further transistor is connected with its collector to the junction of the two resistors at the input transistor collector, with its base to the collector of the input transistor, and with its emitter to the base of the output transistor. It provides a feedback voltage between the collector and the base of the input transistor, reducing excessive current at the input terminals. Another transistor is connected between the base and the emitter of the output transistor to improve switching speed.

(c) R. D. Burtnees "810A PBX Semiconductor Integrated Circuits and Hybrid Technology"; International Conference on Communications, June 1971, pp. 16—23—16—28: Describes a logic gate with voltage feedback to prevent saturation, which is similar to the circuit described in the above cited article of Wu.

(d) B. D. Martin et al. "Advanced Data Systems for the Grand Tour"; IEEE Transactions on Nuclear Science, Vol. NS-18, No. 1, Febr. 1971, pp. 249—257: Describes a TTL gate circuit similar to those disclosed in above cited publications. A multiple-emitter input transistor is connected with its base through a series-connexion of two resistors to a voltage source. An output transistor is connected with its emitter to ground and with its collector to the output terminal. Another transistor is connected with its base to the input transistor collector, with its collector to the output transistor base, and with its collector to the junction of the two series-connected resistors. Two further resistors are provided between base and collector of the input transistor, and between base and emitter of the output transistor, respectively.

It is an object of the invention to provide an improved TTL circuit either having lower power dissipation than prior art TTL circuits but still retaining noise immunity and speed characteristics, or having an enhanced speed characteristic but maintaining power dissipation and noise immunity of known TTL circuits.

Essentially, the invention as set forth in Claims 1 and 3 provides passive feedback in addition to conventional TTL circuits for achieving these objects. This additional feature is well suited for implementation in integrated circuit technology and does not increase the size of TTL cells. It results in an improved "Speed-Power Product" curve for the disclosed circuits in comparison to conventional TTL circuits, and thus allows e.g. a higher packing density for a given speed.

In the following, a description is given of preferred embodiments of the invention as illustrated on the accompanying drawings.

Figure 1 is a prior art TTL circuit diagram and the idealized output waveform thereof showing logic levels.

Figure 2, an embodiment of the invention, is a TTL circuit having full feedback and the idealized output waveform thereof showing logic levels.

Figure 3 discloses speed power product curves for a prior art TTL circuit without feedback (Figure 1), a TTL circuit with full feedback (Figure 2), and a TTL circuit having partial feedback (Figures 4 and 5).

Figure 4, an embodiment of the invention, is a TTL circuit having partial feedback, and the idealized output waveform thereof showing logic levels.

Figure 5, an embodiment of the invention, is a TTL circuit having partial feedback. The TTL circuit includes a direct-coupled inverter.

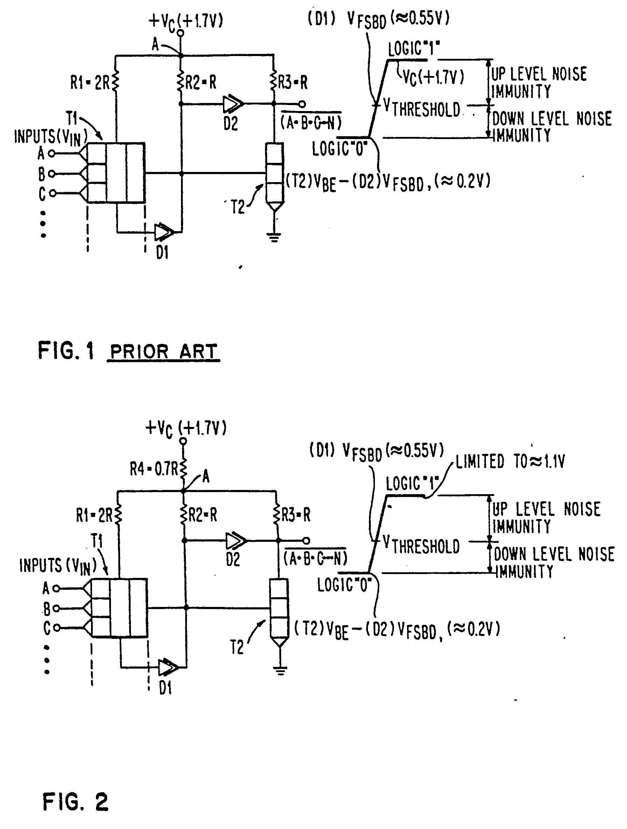

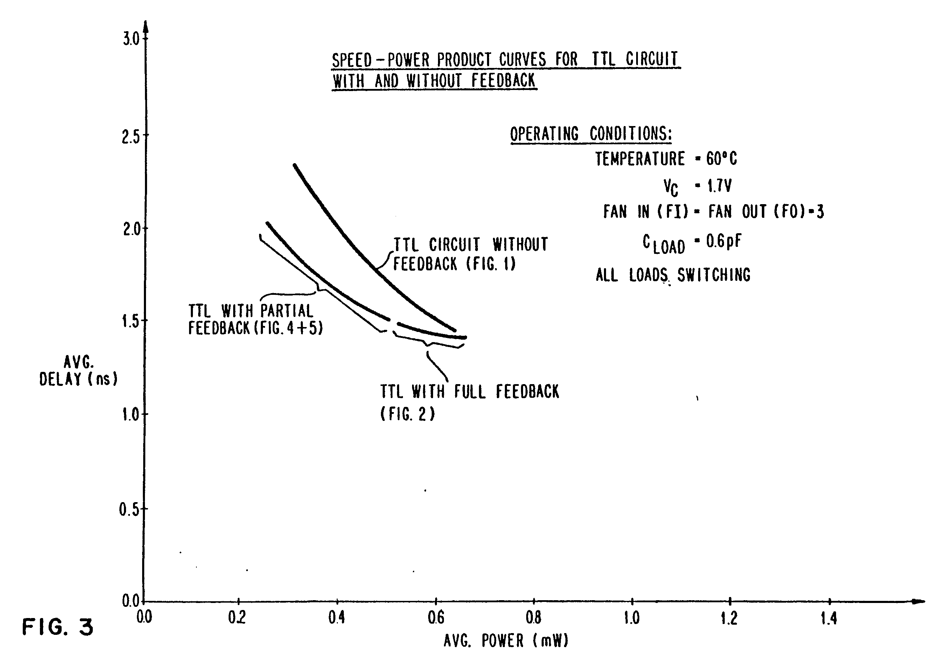

Figure 1 shows a prior art TTL circuit employing a multi-emitter input transistor T1. The emitters A, B, C...N of transistor T1 respectively receive logical binary inputs "1" or "0". The binary inputs ("1" or "0") impressed on A, B, C...N are respectively voltage levels of approximately $+V_c$ (1.7) volts for a binary "1" and approximately 0.2 volts for a binary "0". Transistor T1 has its base connected via resistor R1 to a first source of potential $+V_c$ having magnitude of 1.7 V. The collector of transistor T1 is coupled via resistor R2 to the first potential source $+V_c$. The Schottky barrier diode D1 has its anode connected to the base of transistor T1 and its cathode connected to the collector of T1. Output transistor T2 has its collector connected via resistor R3 to the first potential source $+V_c$, its base connected to the collector of the input transistor T1, and its emitter connected to a second source of potential having a magnitude of zero volts (ground). A Schottky barrier diode D2 has its anode connected to the base of transistor T2 and its cathode connected to the collector of output transistor T2. In the TTL circuit of Figure 1 the resistors R1, R2, and R3 have the following approximate relative magnitudes of 2 R ohms, R ohms and R ohms respectively, where R has a value of approximately 5000 ohms (5k ohms). The output of the TTL circuit of Figure 1 is the NAND logical function $\overline{(A \cdot B \cdot C \cdot ... \cdot N)}$ and is manifested as a potential at an output terminal connected to the collector of T2.

It is to be appreciated that in regard to the prior art TTL circuit of Figure 1 and present invention as fully described hereinafter, the express disclosure of resistance values and potential magnitudes is solely for convenience of explanation and understanding of present invention. Clearly, the invention is not to be limited to these resistor values and magnitudes of potential. The shown ratios of the resistor values, i.e. R1 to R2 to R3 etc. throughout the specification are preferred ratios but the invention is not intended to be limited to these precise values.

Reference is made to Figure 2 which, in accordance with the invention, shows a TTL circuit having full feedback. In Figures 1 and 2, as well as throughout this specification, like reference characters (T1, T2, R1, R2 etc.) make reference to like structure and circuit components. In Figure 2, as in Figure 1, resistors R1, R2 and R3 are each connected to node A. However, in Figure 1 node A is connected directly to the first source of potential ($+V_c$) whereas in Figure 2 node A is connected via resistor R4 to the first source of potential ($+V_c$). In Figure 2 the resistors have the following approximate relative magnitudes R1=2R, R2=R, R3=R and R4=0.7R, where R is approximately equal to 5000 ohms (5k ohms). As in Figure 1, the output of the TTL circuit of Figure 2 is the NAND logical function $\overline{(A \cdot B \cdot C \cdot ... \cdot N)}$ and is manifested as a potential at an output terminal connected to the collector of T2.

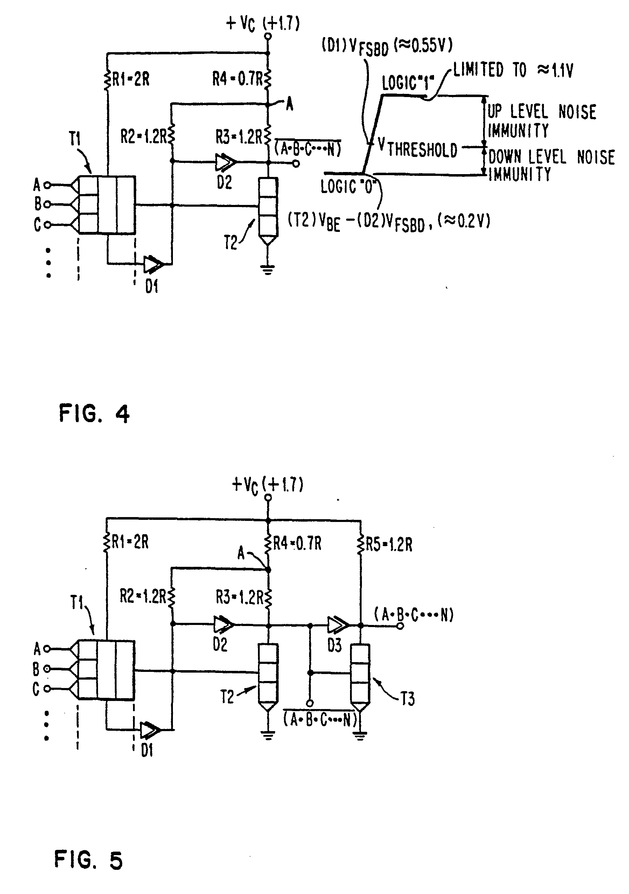

Reference is made to Figures 4 and 5 which, in accordance with the invention, respectively show a TTL circuit having partial feedback. In Figures 4 and 5 resistor R1 is connected to the first source of potential ($+V_c$) whereas in Figure 2 R1 is connected to electrical node A. The TTL circuits with partial feedback, shown in Figures 4 and 5, correspond one to the other with the exception that the TTL circuit of Figure 5 includes a direct-coupled inverter circuit for providing as an additional output the logical AND function $(A \cdot B \cdot C \cdot ... \cdot N)$. The output inverter of the TTL circuit of Figure 5 includes a transistor T3 having its base connected to the collector of transistor T2, its collector connected via resistor R5 to the first potential source ($+V_c$), and its emitter connected to the second potential source (ground). The relative resistor magnitudes for R1, R2, R3, and R4 of Figures 4 and 5, and R5 of Figure 5, are R1=2R, R2=1.2R, R3=1.2R, R4=0.7R, and R5=1.2R. The TTL circuit of Figure 5 provides the logical NAND function $\overline{(A \cdot B \cdot C \cdot ... \cdot N)}$ and the logical AND function $(A \cdot B \cdot C \cdot ... \cdot N)$.

Reference is made to the graph of Figure 3 wherein speed-power product curves for a TTL circuit without feedback, a TTL circuit with full feedback, and a TTL circuit with partial feedback are respectively depicted. In Figure 3 the average power is plotted along the abscissa (x-axis) in milliwatts (mW), and the average delay in nanoseconds (ns) is plotted along the ordinate (y-axis). From an inspection of Figure 3 it will be readily apparent that for a given speed, such as 1.5 nanoseconds, a TTL circuit with partial feedback requires less power than a TTL circuit without feedback. It will also be apparent that over the optimized range a TTL circuit with partial or full feedback, for a given speed (or delay), will require less power than a TTL circuit without feedback and like speed. Correspondingly, for a given circuit power, it will be seen from Figure 3 that a TTL circuit with partial or full feedback will function at a higher speed (lower delay). Also from Figure 3, it will be apparent that partial feedback in TTL circuits is preferable to full feedback.

VLSI results in more logic function being placed on a single chip. This increase in functional density per semiconductor chip reduces overall component count and cost, and enhances system reliability. However, as more circuits are placed on a single chip, the power dissipation requirements per chip rapidly exceed the capability of the package to effectively transfer the heat generated to the cooling medium. Circuit power levels can be lowered, but this is accompanied by an unacceptable reduction in circuit performance. What is needed in VLSI, especially in low-end applications where extraordinary cooling techniques are prohibitive in cost, is a circuit with both low power dissipation and small block delay. The disclosed invention addresses this problem by providing a novel TTL circuit. The novel TTL circuit employs feedback and preferably partial feedback.

In accordance with the invention, the addition of passive feedback to a prior art TTL circuit results in an improved TTL circuit. The improved TTL circuit retains the noise immunity and performance of the prior art TTL circuit but reduces the power dissipation. Namely, the improved TTL circuit has an enhanced "Speed-Power Product" curve as compared to the prior art TTL circuit.

Shown in Figure 1 is a prior art TTL circuit and logic levels generated by same. A DOWN level or logical "0" is equal to $(T2)V_{BE}-(D2)V_{FSBD}$, ($\approx 0.2V$). The threshold ($V_{threshold}$) of the circuit is equal to

$$(T2)V_{BE}+(D1)V_{FSBD}-(T1)V_{BE}\approx(D1)V_{FSBD}(\approx 0.55V).$$

The UP level, or logical "1", is equal to the $+Vc$ supply voltage (1.7 V). The D.C. noise immunity of the circuit is defined as the difference between the operating point (i.e. a logical "0" or logical "1" level) and the circuit's switching point, Vthreshold. As can be seen from Figure 1, the UP level and DOWN level noise immunities for the prior art TTL circuit are unequal. The DOWN level noise immunity of the TTL circuit of Figure 1 is less than the UP level noise immunity, and as such, establishes the noise immunity of the circuit. It follows that in magnitude, the portion of the UP level immunity which exceeds in magnitude the DOWN level immunity cannot be fully utilized, and is unnecessary and wasteful from a power dissipation point of view. The excess portion of the UP level immunity consumes power since a higher voltage than is necessary is achieved. This additional unnecessary consumption of power by the circuit of Figure 1 adds to the heat dissipation problem of VLSI as discussed earlier herein. The higher output voltage (UP level) of the circuit of Figure 1 also results in additional time delay since the next stage (circuit connected to output of circuit under discussion) must wait for the signal to fall from the unnecessarily high voltage to Vthreshold before it will begin to switch. What is needed is a means of limiting the UP level at a voltage lower than the $+Vc$ supply. Namely, a lower UP level which will provide a more symmetric transfer curve. Such a TTL circuit along with its approximately symmetric output (UP and DOWN) levels is shown in Figure 2.

In the TTL circuit of Figure 2 the addition of one resistor (R4) creates a voltage divider network which limits the output UP level at a value equal to:

$$\frac{R2}{R2+R4}[V_C-V_{IN}-(T1)V_{BE}+(D1)V_{FSBD}]+V_{IN}+(T1)V_{BE}-(D1)V_{FSBD}.$$

We have discovered that desirable values for the resistors and Vc of the TTL circuit of Figure 2 are as follows: R1=2R, R2=R and R3=R (where R is 5k ohms), and Vc is +1.7 volts. Referring to Figure 3 the impressive gains in "Speed-Power" product for the circuits of Figures 2, 4 and 5 will be apparent. For example, assuming a fixed block delay of 1.75 ns the TTL circuit of Figure 1 (prior art) will dissipate 0.465 milliwatts while the feedback TTL circuit of Figure 4 will dissipate only 0.34 mW. This is a power savings of 28 per cent.

We have determined from our studies that for chips containing several thousand gates (TTL circuits) per semiconductor chip, the cell size is determined by the number and size of the wiring tracks or channels needed to interconnect the gates on the chip. The additional resistor required for a TTL circuit having feedback may be readily incorporated into the cell without materially enlarging the cell size, which would in turn unfavorably impact chip density. The semiconductor devices (transistors, resistors, and Schottky diodes) required per TTL circuit may be densely placed on a semiconductor chip due to the power saving per circuit. Thus a sizeable number of devices, resulting in additional TTL circuits, may be fabricated on each semiconductor chip.

In order to be useful a circuit must operate over the widest possible range of environmental conditions (power supply and temperature) and process variations. The circuit of Figure 2 may be modified as shown

4

in Figure 4. Moving the base resistor R1 out of the feedback path has a negligible effect upon power dissipation, but significantly extends the range of circuit operation. Referring to Figure 4, a small adjustment to R2 and R3 (for example, R2=R3=1.2R, where R=5k ohms) will provide a slightly less than optimum A.C. design, but the D.C. fan-out capability is increased by as much as 40%.

As discussed earlier herein the cell contains a number of devices (i.e. transistors, resistors, and diodes). One more transistor and resistor, as shown in the circuit of Figure 5, will make it possible to offer a direct-coupled inverter (DCI) in the same cell as the TTL NAND circuit of Figure 4. Typically, 10 to 30% of the circuit count of a single-phase logic technology (e.g. TTL) is dedicated to performing the invert or "not" function. It is thus possible to integrate the invert function (Figure 5) into the same cell as the feedback TTL circuit (Figure 4), leaving circuits available on chip for additional logic function. It will thus be appreciated that the preferred embodiments of the invention are shown in Figures 4 and 5.

**Claims**

1. An improved TTL circuit comprising
a first transistor (T1) having a collector, base, and at least first, second, and third emitters, said first, second, and third emitters of said first transistor respectively receiving a logical binary input A, B, and C;
a second transistor (T2) having an emitter, base, and collector, said emitter of said second transistor being connected to a first potential source, said base of said second transistor being connected to said collector of said first transistor;
a first resistor (R1) connected at one side to said base of said first transistor, for establishing a connexion to a second potential source (+Vc);
second and third resistors (R2, R3) serially connected between said base of said second transistor and said collector of said second transistor, the juncture of said second and third resistors constituting an electrical node (A);
an output terminal connected to said collector of said second transistor, said output terminal manifesting the logical binary function $\overline{A \cdot B \cdot C}$;
characterized in that for providing feedback to enhance the operating characteristics of said TTL circuit,
a fourth resistor (R4) is connected between the junction (A) of said second and third resistors and said second potential source (+Vc), said first resistor being connected at its other side to said junction (A) and thus through said fourth resistor to said second potential source (+Vc).

2. An improved TTL circuit in accordance with claim 1, characterized in that said first resistor (R1) has an ohmic resistance of approximately 2 R ohms, said second resistor (R2) has an ohmic resistance of approximately R ohms, said third resistor (R3) has an ohmic resistance of approximately R ohms, said fourth resistor (R4) has an ohmic resistance of approximately 0.7 R ohms, and said potential provided by said second potential source is greater in magnitude than said potential of said first potential source.

3. An improved TTL circuit comprising
a first transistor (T1) having a collector, base, and at least first, second, and third emitters, said first, second, and third emitters of said first transistor respectively receiving a logical binary input A, B, and C;
a second transistor (T2) having an emitter, base, and collector, said emitter of said second transistor being connected to a first potential source, said base of said second transistor being connected to said collector of said first transistor;
a first resistor (R1) connected at one side to said base of said first transistor, for establishing a connexion to a second potential source (+Vc);
second and third resistors (R2, R3) serially connected between said base of said second transistor and said collector of said second transistor, the juncture of said second and third resistors constituting an electrical node (A);
an output terminal connected to said collector of said second transistor, said output terminal manifesting the logical binary function $\overline{A \cdot B \cdot C}$;
characterized in that for providing partial feedback to enhance the operating characteristics of said TTL circuit,
a fourth resistor (R4) is connected between the junction (A) of said second and third resistors and said second potential source (+Vc), said first resistor being connected at its other side directly to said second potential source (+Vc).

4. An improved TTL circuit in accordance with claim 3, characterized by a third transistor (T3) having an emitter, base, and collector, said emitter of said third transistor being connected to said first potential source, said collector of said third transistor being connected to said collector of said second transistor;
a fifth resistor (R5) connected between said collector of said third transistor and said second potential source; and
a second output terminal connected to said collector of said third transistor, said second output terminal manifesting the logical binary function $A \cdot B \cdot C$ in response to said first transistor having respectively impressed thereon the logical binary inputs A, B and C (Figure 5).

5. An improved TTL circuit in accordance with claim 3 or 4, characterized in that said first resistor (R1) has an ohmic resistance of approximately 2R ohms, said fourth resistor (R4) has an ohmic resistance of approximately 0.7 R ohms, and the other resistors (R2, R3, R5) each have an ohmic resistance of approximately 1.2 R ohms, and said potential provided by said second potential source is greater in magnitude than said potential of said first potential source.

6. An improved TTL circuit in accordance with claim 2 or 5, characterized in that R has an ohmic value of approximately 5k ohms, the first potential source provides a potential of approximately zero (0) volts, and the second potential source provides a potential of approximately +1.7 volts.

7. An improved TTL circuit in accordance with claim 1 or 3 characterized in that a first Schottky barrier diode (D1) is connected across the base-collector junction of said first transistor (T1) and a second Schottky barrier diode (D2) is connected across the base-collector junction of said second transistor (T2).

**Patentansprüche**

1. Verbesserte TTL-Schaltung, enthaltend
einen ersten Transistor (T1) mit einem Kollektor, einer Basis und mindestens einem ersten, zweiten und dritten Emitter, wobei der erste, zweite und dritte Emitter dieses ersten Transistors je ein binäres logisches Eingangssignal A, B und C erhalten;
einen zweiten Transistor (T2) mit einem Emitter, einer Basis und einem Kollektor, wobei der Emitter dieses zweiten Transistors mit einer ersten Spannungsquelle verbunden ist, und wobei die Basis dieses zweiten Transistors mit dem Kollektor des ersten Transistors verbunden ist;
einen ersten Widerstand (R1), der auf einer Seite mit der Basis des ersten Transistors verbunden ist, um eine Verbindung zu einer zweiten Spannungsquelle (+Vc) herzustellen;
einen zweiten und einen dritten Widerstand (R2, R3), welche in Reihe zwischen der Basis des zweiten Transistors und dem Kollektor des zweiten Transistors geschaltet sind, wobei die Verbindungsstelle des zweiten und dritten Widerstandes einen elektrischen Knotenpunkt (A) bildet;
einen Ausgangsanschluss, welcher mit dem Kollektor des zweiten Transistors verbunden ist, wobei an diesem Ausgangsanschluss die binäre logische Funktion $\overline{A \cdot B \cdot C}$ ansteht;
dadurch gekennzeichnet, dass zwecks Bewirkung einer Rückkopplung zur Verbesserung des Betriebsverhaltens der TTL-Schaltung
ein vierter Widerstand (R4) zwischen dem Verbindungspunkt (A) des zweiten und des dritten Widerstandes sowie der zweiten Spannungsquelle (Vc) geschaltet ist, wobei der erste Widerstand an seiner anderen Seite mit dem Knotenpunkt (A) verbunden ist und auf diese Weise über den vierten Widerstand mit der zweiten Spannungsquelle (+Vc).

2. Verbesserte TTL-Schaltung gemäss Anspruch 1, dadurch gekennzeichnet, dass der erste Widerstand (R1) einen ohmschen Widerstand von etwa 2 R Ohm hat, dass der zweite Widerstand (R2) einen ohmschen Widerstand von etwa R Ohm hat, dass der dritte Widerstand (R3) einen ohmschen Widerstand von etwa R Ohm hat, dass der vierte Widerstand (R4) einen ohmschen Widerstand von etwa 0.7 R Ohm hat, und dass die Spannung, welche von der zweiten Spannungsquelle abgegeben wird, grösser als die Spannung der ersten Spannungsquelle ist.

3. Verbesserte TTL-Schaltung, enthaltend
einen ersten Transistor (T1) mit einem Kollektor, einer Basis und mindestens einem ersten, zweiten und dritten Emitter, wobei der erste, zweite und dritte Emitter dieses ersten Transistors je ein binäres logisches Eingangssignal A, B und C erhalten;
einen zweiten Transistor (T2) mit einem Emitter, einer Basis und einem Kollektor, wobei der Emitter dieses zweiten Transistors mit einer ersten Spannungsquelle verbunden ist, und wobei die Basis dieses zweiten Transistors mit dem Kollektor des ersten Transistors verbunden ist;
einen ersten Widerstand (R1), der auf einer Seite mit der Basis des ersten Transistors verbunden ist, um eine Verbindung zu einer zweiten Spannungsquelle (+Vc) herzustellen;
einen zweiten und einen dritten Widerstand (R2, R3), welche in Reihe zwischen der Basis des zweiten Transistors und dem Kollektor des zweiten Transistors geschaltet sind, wobei die Verbindungsstelle des zweiten und dritten Widerstandes einen elektrischen Knotenpunkt (A) bildet;
einen Ausgangsanschluss, welcher mit dem Kollektor des zweiten Transistors verbunden ist, wobei an diesem Ausgangsanschluss die binäre logische Funktion $\overline{A \cdot B \cdot C}$ ansteht;
dadurch gekennzeichnet, dass zwecks Bewirkung einer partiellen Rückkopplung zur Verbesserung des Betriebsverhaltens der TTL-Schaltung
ein vierter Widerstand (R4) zwischen dem Verbindungspunkt (A) des zweiten und des dritten Widerstandes sowie der zweiten Spannungsquelle (Vc) geschaltet ist, wobei der erste Widerstand an seiner anderen Seite direkt mit der zweiten Spannungsquelle (+Vc) verbunden ist.

4. Verbesserte TTL-Schaltung gemäss Anspruch 3, gekennzeichnet durch
einen dritten Transistor (T3), welcher einen Emitter, eine Basis und einen Kollektor hat, wobei der Emitter dieses dritten Transistors mit der ersten Spannungsquelle verbunden ist, und wobei der Kollektor des dritten Transistors mit dem Kollektor des zweiten Transistors verbunden ist,
einen fünften Widerstand (R5), welcher zwischen dem Kollektor des dritten Transistors und der zweiten Spannungsquelle geschaltet ist; und
einen zweiten Ausgangsanschluss, der mit dem Kollektor des dritten Transistors verbunden ist, wobei dieser zweite Ausgangsanschluss die binäre logische Funktion $A \cdot B \cdot C$ abgibt, wenn dem ersten Transistor die logischen binären Eingangssignale aufgeprägt werden.

5. Verbesserte TTL-Schaltung gemäss Anspruch 3 oder 4, dadurch gekennzeichnet, dass der erste Widerstand (R1) einen ohmschen Widerstand von etwa 2R Ohm hat, dass der vierte Widerstand (R4) einen ohmschen Widerstand von etwa 0.7 R Ohm hat, dass von den übrigen Widerständen jeder einen ohmschen Widerstand von etwa 1.2 R Ohm hat, und dass die Spannung, welche von der zweiten Spannungsquelle abgegeben wird, grösser als die Spannung der ersten Spannungsquelle ist.

6. Verbesserte TTL-Schaltung gemäss Anspruch 2 oder 5, dadurch gekennzeichnet, dass R ein ohmscher Widerstand von etwa 5 kOhm ist, dass die erste Spannungsquelle eine Spannung von etwa null (0) Volt abgibt, und dass die zweite Spannungsquelle eine Spannung von etwa +1.7 Volt abgibt.

7. Verbesserte TTL-Schaltung gemäss Anspruch 1 oder 3, dadurch gekennzeichnet, dass eine erste Schottky-Diode (D1) parallel zur Basis-Kollektor-Strecke des ersten Transistors (T1) geschaltet ist, und dass eine zweite Schottky-Diode (D2) parallel zur Basis-Kollektor-Strecke des zweiten Transistors (T2) geschaltet ist.

**Revendications**

1. Circuit TTL amélioré comprenant:

un premier transistor (T1) comprenant un collecteur, une base et au moins des premier, deuxième et troisième émetteurs, ces premier, deuxième et troisième émetteurs du premier transistor recevant respectivement une entrée binaire logique A, B, et C;

un second transistor (T2) ayant un émetteur, une base et un collecteur, l'émetteur de ce second transistor étant connectée à une première source de potentiel, la base du second transistor étant connectée au collecteur du premier transistor;

une première résistance (R1) connectée d'un côté de la base du premier transistor, pour établir une connexion vers une seconde source de potentiel (+Vc);

des deuxième et troisième résistances (R2, R3) connectées en série entre la base du second transistor et le collecteur du second transistor, le point de raccordement des deuxième et troisième résistances constituant un noeud électrique (A);

une borne de sortie connectée au collecteur du second transistor, cette borne de sortie fournissant la fonction binaire logique $\overline{A \cdot B \cdot C}$;

caractérisé en ce que, pour fournir une réaction pour renforcer les caractéristiques de fonctionnement de ce circuit TTL,

une quatrième résistance (R4) est connectée entre le point de raccordement (A) des deuxième et troisième résistance et·la seconde source de potentiel (+Vc), la première résistance étant connectée par. son autre borne à ce point de raccordement (A) et, ainsi, par l'intermédiaire de la quatrième résistance à la seconde source de potentiel (+Vc).

2. Circuit TTL amélioré selon la revendication 1, caractérisé en ce que la première résistance (R1) a une valeur ohmique d'environ 2R ohms, la seconde résistance (R2) a une valeur ohmique d'environ R ohms, la troisième résistance (R3) a une valeur ohmique d'environ R ohms, la quatrième résistance (R4) a une valeur ohmique d'environ 0,7 R ohms, et le potentiel fourni par la seconde source de potentiel est supérieur en amplitude au potentiel de la première source de potentiel.

3. Circuit TTL amélioré comprenant:

un premier transistor (T1) muni d'un collecteur, d'une base et d'au moins des premier, deuxième et troisième émetteurs, les premier, deuxième et troisième émetteurs du premier transistor recevant respectivement une entrée binaire logique A, B, et C;

un second transistor (T2) ayant un émetteur, une base et un collecteur, l'émetteur du second transistor étant connecté à une première source de potentiel, la base du second transistor étant connectée au collecteur du premier transistor;

une première résistance (R1) connectée d'un côté à la base du premier transistor pour établir une connexion avec une seconde source de potentiel (+Vc);

des deuxième et troisième résistances (R2, R3) connectées en série entre la base du second transistor et le collecteur de ce second transistor, le point de raccordement des deuxième et troisième résistances constituant un noeud électrique (A);

une borne de sortie connectée au collecteur du second transistor, cette borne de sortie fournissant la fonction binaire logique $\overline{A \cdot B \cdot C}$;

caractérisé en ce que, pour fournir une réaction partielle pour renforcer les caractéristiques de fonctionnement du circuit TTL,

une quatrième résistance (R4) est connectée entre le point de raccordement (A) des deuxième et troisième résistances et la seconde source de potentiel (+Vc), la première résistance étant connectée par son autre borne directement à la seconde source de potentiel (+Vc).

4. Circuit TTL amélioré selon la revendication 3, caractérisé par

un troisième transistor (T3) ayant un émetteur, une base et un collecteur, l'émetteur du troisième transistor étant connecté à la première source de potentiel, le collecteur du troisième transistor étant connecté au collecteur du second transistor;

une cinquième résistance (R5) connectée entre le collecteur du troisième transistor et la seconde source de potentiel, et

une seconde borne de sortie connectée au collecteur du troisième transistor, cette seconde borne de sortie fournissant la fonction binaire logique A · B · C · en réponse au fait que le premier transistor a respectivement reçu les entrées binaires logiques A, B et C (figure 5).

5. Circuit TTL amélioré selon la revendication 3 ou 4, caractérisé en ce que la première résistance (R1) a une valeur ohmique d'environ 2R ohms, la quatrième résistance (R4) a une résistance ohmique d'environ 0,7 R ohms et les autres résistances (R2, R3 et R5) ont chacune une résistance ohmique d'environ 1,2 R ohms, et le potentiel fourni par la seconde source de potentiel est supérieur en amplitude au potentiel de la première source de potentiel.

6. Circuit TTL amélioré selon la revendication 2 ou 5, caractérisé en ce que R a une valeur ohmique d'environ 5k ohms, la première source de potentiel fournit un potentiel d'environ zéro (0) volt, et la seconde source de potentiel fournit un potentiel d'environ +1,7 volts.

7. Circuit TTL amélioré selon l'une des revendications 1 ou 3, caractérisé en ce qu'une première diode à barrière de Schottky (D1) est connectée aux bornes de la jonction base-collecteur du premier transistor (T1) et une seconde diode à barrière de Schottky (D2) est connectée aux bornes de la jonction base-collecteur du second transistor (T2).

+V$_C$(+1.7V)

A

R1=2R    R2=R    R3=R

D2

T1

INPUTS(V$_{IN}$)

A

B

C

$\overline{(A \cdot B \cdot C \cdots N)}$

(T2)V$_{BE}$−(D2)V$_{FSBD}$,(≈0.2V)

T2

D1

(D1) V$_{FSBD}$(≈0.55V)

LOGIC"1"

V$_C$(+1.7V)

V$_{THRESHOLD}$

LOGIC"0"

UP LEVEL NOISE IMMUNITY

DOWN LEVEL NOISE IMMUNITY

## FIG. 1  PRIOR ART

+V$_C$ (+1.7V)

R4=0.7R    A

R1=2R    R2=R    R3=R

D2

T1

INPUTS (V$_{IN}$)

A

B

C

$\overline{(A \cdot B \cdot C \cdots N)}$

(T2)V$_{BE}$−(D2)V$_{FSBD}$,(≈0.2V)

T2

D1

(D1) V$_{FSBD}$(≈0.55V)    LIMITED TO≈1.1V

LOGIC"1"

V$_{THRESHOLD}$

LOGIC"0"

UP LEVEL NOISE IMMUNITY

DOWN LEVEL NOISE IMMUNITY

## FIG. 2

1

FIG. 3

SPEED - POWER PRODUCT CURVES FOR TTL CIRCUIT
WITH AND WITHOUT FEEDBACK

OPERATING CONDITIONS:
TEMPERATURE = 60°C
$V_C$ = 1.7V
FAN IN (FI) = FAN OUT (FO) = 3
$C_{LOAD}$ = 0.6pF
ALL LOADS SWITCHING

TTL CIRCUIT WITHOUT
FEEDBACK (FIG. 1)

TTL WITH PARTIAL
FEEDBACK (FIG. 4+5)

TTL WITH FULL FEEDBACK
(FIG. 2)

AVG.
DELAY (ns)

AVG. POWER (mW)

0 114 256

FIG. 4

FIG. 5